# EUROPEAN PATENT APPLICATION

(11) **EP 1 035 567 A2**
(43) Date of publication of application: **13.09.2000**
(21) Application number: 00301572.4
(22) Date of filing: 28.02.2000
(51) Int. Cl.: H01L 21/28

(54) **A process for fabricating a device with shallow junctions**

(30) Priority: 12.03.1999 US 268447
(71) Applicant: LUCENT TECHNOLOGIES INC., Murray Hill, New Jersey 07974-0636 (US)
(72) Inventor: Bude, Jeffrey Devin, New Providence, New Jersey 07974 (US); Silverman, Paul Joseph, Millburn, New Jersey 07041 (US); Vuong, Thi-Hong-Ha, Berkeley Heights, New Jersey 07922 (US)
(74) Representative: Johnston, Kenneth Graham

(57) **Abstract**

A process for device fabrication is disclosed. In the process a dielectric layer is formed by thermal oxidation of a semiconductor substrate that has been damaged by ion implantation. The concentration of the implanted ions is about 6 x 10¹⁶/cm³ to about 3 x 10²¹/cm³. The ions are either a dopant, a non-dopant, or a combination of non-dopant. The dielectric layer formed on the damaged substrate has improved lifetime and reliability compared with dielectric layers that are not damaged to the same extent by ion implantation.

## Description

### Background of the Invention

### Technical Field

This invention is directed to processes for semiconductor device fabrication in which the semiconductor devices have a thin gate dielectric layer formed on a semiconductor substrate.

### Art Background

Field effect devices, such as field effect transistors, are fundamental components in modern electronics. They are basic components in most digital and many analog circuits, including circuits for data processing and telecommunications. Indeed it has been surmised that field effect transistors are among the most numerous of human-made objects.

Field effect devices typically comprise a controllable-conductivity path, called a channel, disposed between a source and a drain. A gate electrode is formed on a thin dielectric film overlying the channel. For example, the source and the drain can be n-type regions of silicon connected by a p-type channel region. The gate electrode can be a conductive, doped polysilicon layer formed on a thin layer of oxidized silicon overlying the channel.

If no voltage is applied to the gate, current cannot flow from the source to the channel or from the channel to the drain. However, if a sufficient positive voltage is applied to the gate, electrons are induced into the channel region, thereby creating a continuous n-type conductive path between the source and the drain.

The reliable operation of the integrated circuits is critically dependent on the reliability of the increasingly thin dielectric layers used in the circuit devices. As transistors have become smaller and more densely packed, the dielectrics have become thinner. Capacitor and gate dielectrics are now often less than 80 angstroms in thickness. With the arrival of ULSI technology, gate dielectric thickness is approaching 50 angstroms or less. For integrated circuits to work, these thin layers in each of thousands of different transistors must insulate the gate, and resist damage from current. In addition, these properties should not degrade significantly over the lifetime of the device. These demanding requirements may soon exceed the capacities of conventional silicon oxide layers.

Accordingly, devices having gate dielectric layers with improved reliability and improved lifetimes are sought.

### SUMMARY OF THE INVENTION

In accordance with the invention, a semiconductor device is provided with a thin dielectric layer that is formed on a semiconductor (e.g. silicon) substrate that has been damaged by ion implantation. Examples of semiconductor devices include complementary metal-oxide-semiconductor (CMOS) devices, metal-oxide-semiconductor field effect transistor (MOSFET) devices, MOS capacitors, and EEPROM (electrically erasable programmable read only memory) devices.

In the present invention, ion implantation is used to introduce defects into the semiconductor substrate. Ion implantation is a controllable and reproducible technique that is typically used to introduce dopant atoms into materials such as crystalline semiconductor substrates. Semiconductor substrates are doped in order to introduce certain electrical properties into the substrate. During ion implantation of dopant atoms, dopant atoms are ionized, accelerated, and directed at the crystalline semiconductor substrate. The dopant atoms enter the crystal lattice of the silicon substrate, collide with silicon atoms and gradually lose energy, finally coming to rest at some depth within the crystal lattice. Adjusting the acceleration energy controls the average depth. The dopant dose is controlled by monitoring the ion current during implantation.

One consequence of ion implantation is that defects are introduced into the crystal lattice. In silicon substrates, these defects are silicon atoms that are dislocated from the crystal lattice during the implant. The present invention is directed to a process for semiconductor device fabrication and specifically, a process for fabricating devices in which the silicon substrate is damaged by ion implantation after which a layer of dielectric material is formed on the damaged substrate.

In the process of the present invention, the implanted ions are either dopants or non-dopants. In the context of the present invention, dopants are atoms that donate free electrons or holes at the device operating temperature. Boron, BF₂, and arsenic are examples of dopant atoms. Non-dopants are ions that do not donate free electrons or holes at the device operating temperature. Nitrogen and argon are examples of non-dopant impurities. Other examples of non-dopants are ions that are among the elemental constituents of the semiconductor substrate. For example, if the semiconductor substrate is silicon or silicon-germanium, then silicon is a non-dopant.

It is advantageous if the concentration of implanted ions is about 6 x 10¹⁶/cm³ to about 3 x 10²¹/cm³ in order to obtain the requisite amount of damage. The implanted ions are either dopants or non-dopants, or a combination of dopants and non-dopants. However, this does not limit the amount of dopant that can be introduced into the substrate. One skilled in the art will recognize that dopants can be introduced into the substrate using mechanisms other than ion implantation. Thus specifying a level of substrate damage does not limit the degree to which the substrate is doped. Furthermore, the damage can be provided by some combination of dopants and non-dopants. Therefore, the amount of ion implantation damage is not limited by the desired concentration of dopant in the substrate.

In one embodiment of the process of the present invention, ion implantation is used to introduce interstitial silicon atoms of the desired concentration into the semiconductor substrate. In the embodiment of the present invention wherein the substrate is a silicon or silicon-germanium substrate, it is advantageous if silicon atoms are used to generate the interstitial silicon atoms in the substrate. However, other non-dopants (i.e. atoms which, upon incorporation into the silicon lattice following an anneal do not donate electrons or holes) such as argon, neon, and germanium are contemplated as suitable. The interstitials are introduced into the substrate in the desired quantity, either before or after dopants (e.g. phosphorus, boron, etc.) are introduced into the substrate. The region of the substrate that is damaged is the region of the substrate on which the gate dielectric layer is subsequently formed.

Techniques for ion implantation into the substrate are well known to one-skilled in the art. Conventional conditions are contemplated as suitable, provided that the conditions do not introduce a point defect concentration in the substrate that exceeds about 5 x 10²¹ defects/cm³. Because of the limitation on the number of point defects, it can be advantageous to dope the substrate using a technique other than ion implantation. For example, dopant is introduced into the substrate by forming a doped layer of polycrystalline material on the substrate and subjecting the substrate to conditions that drive the dopant from the polycrystalline material into the substrate. The conditions used to drive the dopant into the substrate are not critical. Conventional expedients for driving the dopant into the substrate, e.g., placing the silicon substrate in an atmosphere that contains the dopant gas and implantation, are also contemplated as suitable. If implantation is used to introduce the dopant into the substrate followed by ion implantation of a non-dopant, however, the collective damage from the implant must be within the specified range.

The non-dopant is then implanted into the substrate using a dose and energy that are selected to provide a concentration of point defects in the substrate of about 6 x 10¹⁶ atoms/cm³ to about 3 x 10²¹ atoms/cm³. For implant energies of about 0.1 keV to about 10 MeV, this corresponds to an implant dose in the range of about 6 x 10¹¹ atoms/cm² to about 3 x 10¹⁶ atoms/cm².

After the implantation, the oxidized silicon (i.e. the sacrificial oxide) on the surface of the semiconductor substrate is removed. The thin dielectric layer is then grown on the substrate using a thermal oxidation step. Thermal oxidation conditions are well known to one skilled in the art. Thermal oxidation occurs in an oxygen-containing atmosphere at a temperature in the range of about 700°C to about 1100°C. The duration of the thermal oxidation depends upon the desired thickness of the dielectric layer and is readily determined by one skilled in the art. Examples of suitable dielectric layer thicknesses are in the range of about 7 angstroms to about 200 angstroms. After the dielectric layer is formed, conventional processing techniques are used to form the remainder of the device. Conventional processing techniques are compatible with the process of the present invention. Consequently, materials and conditions for forming the remainder of the device are not discussed herein. Materials and conditions for forming the remaining portion of the desired device are readily selected by one skilled in the art.

The present invention is further described in terms of specific examples. These examples are provided to further illustrate the invention. These examples are not intended to circumscribe the scope of the present invention.

### BRIEF DESCRIPTION OF THE DRAWINGS

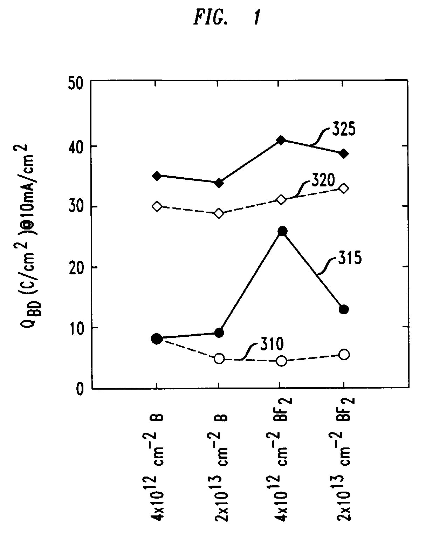

FIG. 1 compares the sustained charge before breakdown (Q_{BD}) for silicon dioxide dielectric layers formed on doped substrates that were further damaged by a silicon implant with dielectrics formed on doped substrates that were not further damaged by silicon implant.

### DETAILED DESCRIPTION

The process of the present invention is used to fabricate a semiconductor device with a thin dielectric layer (in the context of the present invention, a thin dielectric layer is a dielectric layer that has a thickness in the range of about 7 angstroms to about 200 angstroms). In the process of the present invention, the thin dielectric layer is formed by thermal oxidation of a semiconductor substrate that has been damaged by ion implantation. The implant of either dopant atoms or non-dopant atoms (e.g. silicon or other atoms that do not donate electrons or holes) is used to introduce a desired degree of damage in a semiconductor substrate.

Conventional conditions for ion implantation into a crystalline substrate are contemplated as suitable, provided that the conditions do not introduce a point defect concentration in the substrate that exceeds about 5 x 10²¹ defects/cm³. The present process does not require that the substrate be doped. There is also no requirement that the substrate, if doped, be doped by ion implantation. Consequently, the present invention contemplates that the substrate is damaged to the desired degree by the implant of a non-dopant and that the dopant, if present at all, is introduced into the substrate by any conventional expedient. Doping mechanisms are well known to one skilled in the art. In addition to ion implantation, such methods include deposited layers of either polysilicon or crystalline silicon or silicon germanium which are heavily doped (e.g. dopant concentration in excess of 1 x 10²⁰ atoms/cm³) during the deposition and the introduction of dopant from a dopant gas.

The non-dopant is then implanted into the substrate using a dose and energy that are selected to provide a concentration of point defects in the substrate of about 6 x 10¹⁶ atoms/cm³ to about 3 x 10²¹ atoms/cm³. For implant energies of about 0.1 keV to about 1 MeV, this corresponds to an implant dose in the range of about 6 x 10¹¹ atoms/cm² to about 3 x 10¹⁶ atoms/cm².

After the substrate is damaged to the desired degree, any oxide on the surface of the semiconductor substrate is then removed using conventional wet etch expedients (e.g. aqueous HF) well known to one skilled in the art. The thin dielectric layer is then grown on the substrate using a thermal oxidation step. Thermal oxidation conditions are well known to one skilled in the art. Thermal oxidation occurs in an oxygen-containing atmosphere at a temperature in the range of about 700°C to about 1100°C. The duration of the thermal oxidation depends upon the desired thickness of the dielectric layer and is readily determined by one skilled in the art. Examples of suitable dielectric layer thicknesses are in the range of about 7 angstroms to about 200 angstroms. The remaining portions of the device are then formed using conventional processing techniques well known to one skilled in the art. Consequently, the formation of the remaining portion of the device is not described herein.

### Example 1

MOS capacitors were fabricated by first forming a 20 nm thick layer of sacrificial oxide on 100 silicon substrates. The substrates were then divided into four equal groups, and each group was implanted using a different recipe. The first group was implanted with a 4 x 10¹²cm⁻² dose of boron at an energy of 40 keV. The second group was implanted with a 2 x 10¹³ cm⁻² dose of boron at an energy of 40 keV. The third group was implanted with a 4 x 10¹²cm⁻² dose of boron difluoride (BF₂) at an energy of 40 keV. The fourth group was implanted with a 2 x 10¹³cm⁻² dose of BF₂ at an energy of 40 keV.

One-half of the wafers in each group received a second implant. That implant was a 1 x 10¹⁴cm⁻² dose of silicon at an energy of 40 keV. The purpose of this implant was to introduce further implant damage without further doping the substrate. Since each group was split into two by virtue of the fact that the only one-half of each group was subjected to the silicon implant, eight groups were obtained.

The sacrificial oxide was then removed using an aqueous solution (15:1) of hydrofluoric acid. A layer of thermally grown silicon oxide was then formed on the surface of the substrates. The oxidation occurred at 850°C in a dry oxygen atmosphere that contained two-percent dichloroethylene (DCE). For one-half of the wafers, the duration of the oxidation was controlled to form an oxide layer with a thickness of 60 angstroms on the wafers. For the other one-half of the wafers, the duration of the oxidation was controlled to form an oxide layer with a thickness of 120 angstroms on the wafers. Since each group was split into two by virtue of the fact that a 60 angstrom thick layer of oxide was formed on one-half of each group and a 120 angstrom thick layer of oxide was formed on the other one-half, sixteen groups were obtained.

After the layer of silicon oxide was formed on the substrate surface, the capacitor gates were formed by depositing a 2800 angstrom-thick layer of polysilicon on the substrates. The polysilicon was doped with a 4x10¹⁵cm⁻² dose of arsenic at an energy of 60 keV. The dopant was then activated using a rapid thermal anneal at 1050°C for five seconds. Aluminum was then deposited on the doped polysilicon and the structures were then etched to form capacitor patterns. The resulting capacitors were 200 µm by 200 µm (i.e. a capacitor area of 4 x 10⁻⁴cm⁻²).

Simultaneous quasistatic and high-frequency (100 kHz) C-V measurements were performed. The high-frequency data demonstrated that the wafers in which the silicon implant were performed had a reduced accumulation capacitance, ΔC_{damage}, compared to the wafers which were not subjected to the silicon implant. This was determined by measuring the capacitance of the above-described capacitors over a range of substrate biases (-4 volts to -2 volts). In all instances, for a given oxidation time and substrate dopant implant, the capacitance of the capacitors formed on the doped substrates subsequently damaged by a silicon implant was less than the capacitance of the capacitors formed on doped substrates not damaged by a subsequent silicon implant. For example, the capacitance of capacitors with a 60-angstrom thick oxide formed on a boron-implanted substrate subsequently damaged by a silicon implant was compared to the capacitance of capacitors of like oxide thickness but formed on a boron-implanted substrate not damaged by a silicon implant. The capacitance of the capacitors formed on the substrates damaged by the silicon implant was, on average, 7 pf less than the capacitance of the capacitors formed on the substrates not damaged by the silicon implant. For the capacitors with the 120 angstrom thick oxide, the ΔC_{damage} attributed to the silicon implant was about 2 pf less. The ΔC_{damage} corresponds to an observed increase (ranging between one and four angstroms) in the electrically measured gate oxide thickness. The ΔC_{damage} that is attributed to the silicon implant is much larger than the ΔC observed among the wafers that were not subjected to the silicon implant.

The reliability of oxides grown on the implanted substrates not damaged by a subsequent silicon implant is compared with the reliability of oxides grown on implanted substrates that were damaged by a subsequent silicon implant. Specifically, the Q_{BD} for the oxide formed in each of the sixteen above-described groups were measured. Q_{BD} is the total charge sustained by the gate oxide before breakdown occurs. The QBD method of evaluating oxide reliability is advantageous because a constant current is used for the testing and because the QBD measurement is independent of the oxide thickness. Therefore, QBD measurement permits comparison of the reliability of oxides having different thicknesses. Generally, a high QBD indicated a high reliability. A low QBD indicated low reliability.

In this example, the Q_{BD} was measured by passing a current of 10 mA/cm² through the oxide. The results of the Q_{BD} for the oxides in each of the sixteen groups are illustrated in FIG. 1. Specifically, the Q_{BD} for 60-angstrom thick silicon dioxide dielectrics formed on substrates doped using the previously described dopants and dopant doses that were not subsequently damaged by a silicon implant are illustrated in line 310. The Q_{BD} for 60-angstrom thick silicon dioxide dielectrics formed on substrates doped using the previously described dopants and dopant doses that were subsequently damaged by a silicon implant are illustrated in line 315. The Q_{BD} for 120-angstrom thick silicon dioxide dielectrics formed on substrates doped using the previously described dopants and dopant doses that were not subsequently damaged by a silicon implant are illustrated in line 320. The Q_{BD} for 120-angstrom thick silicon dioxide dielectrics formed on substrates doped using the previously described dopants and dopant doses that were subsequently damaged by a silicon implant are illustrated in line 325.

FIG. 1 illustrates that the oxides formed on the substrates that were formed on the doped substrates with additional damage from a silicon implant had a higher Q_{BD} (i.e. greater reliability) than the oxides formed on doped substrates that were not further damaged by a silicon implant. This result was independent of the specific dopant (boron or BF₂) and the dopant dose (4 x 10¹²/cm² and 2 x 10¹³/cm². The observed increase in Q_{BD} ranged up to a maximum of 26 C/cm² for the 60-angstrom thick oxides formed on substrates doped with the 4 x 10¹²/cm² dose of BF₂ and further damaged with a silicon implant.

## Claims

1. A process for device fabrication comprising:
implanting atoms into a semiconductor substrate, wherein the implant energy and the number of atoms introduced into the substrate are selected to introduce a concentration of point defects in the substrate in the range of about 6 x 10¹⁶/cm³ to about 3 x 10²¹/cm³; and
forming a layer of dielectric material on the semiconductor substrate with the point defects therein.

2. The process of claim 1 wherein the implanted atoms are selected from the group consisting of dopants, non-dopants, and combinations of dopants and non-dopants.

3. The process of claim 2 wherein the substrate is a silicon substrate.

4. The process of claim 3 wherein the layer of dielectric material is formed by thermal oxidation of the silicon substrate.

5. The process of claim 3 wherein the thermal oxidation occurs at a temperature in the range of about 700°C to about 1100°C and for a duration sufficient to form a layer of dielectric material having a thickness of about 7 angstroms to about 1100 angstroms.

6. The process of claim 5 wherein the implanted atoms are a combination of dopant atoms and silicon atoms having a combined dose of about 6 x 10¹¹ atoms/cm² to about 3 x 10¹⁶ atoms/cm².
